# EUROPEAN PATENT APPLICATION

(11) **EP 4 592 656 A1**
(43) Date of publication of application: **30.07.2025**
(21) Application number: 25150866.9
(22) Date of filing: 09.01.2025
(51) Int. Cl.: G01K 7/18, H10D 30/47, H10D 89/60

(54) **LINEAR TEMPERATURE SENSOR WITH REDUCED NUMBER OF TERMINALS IN HEMT TECHNOLOGY**

(30) Priority: 25.01.2024 IT 202400001401
(71) Applicant: STMicroelectronics International N.V., 1228 Plan-les-Ouates, Geneva (CH)
(72) Inventor: SELGI, Lorenzo Maurizio, 95013 FIUMEFREDDO DI SICILIA (CT) (IT); IUCOLANO, Ferdinando, 95030 GRAVINA DI CATANIA (CT) (IT)
(74) Representative: Studio Torta S.p.A.

(57) **Abstract**

A semiconductor device (50) comprising: a semiconductor body (52); a gate region (60); a field plate (84), of pure metal material, laterally spaced from the conductive gate region (60), the field plate (84) having, in a top-plan view, a strip-like shape with main extensions along a first direction (Y), the strip-like shape having a first and a second end opposite to one another along said first direction (Y); a first conductive pad (96a) in electrical contact with the field plate (84) at the first end through a first connecting region; a second conductive pad (104) in electrical contact with the field plate (84) at the second end through a second connecting region; and a third conductive pad (106) in electrical contact with the field plate (84) at the second end through a third connecting region. The conductive pads allow the use of the field plate (84) as a temperature sensor.

## Description

The present invention relates to a semiconductor device, such as a High Electron Mobility Transistor (HEMT) or a Laterally Diffused Metal-Oxide-Semiconductor (LDMOS) device, including a field plate region operable as a temperature sensor; to a system comprising the semiconductor device; and to a method of operating the semiconductor device as a temperature sensor.

As known, the HEMT device, also known as heterostructure field effect transistors (HFET), are finding wide diffusion, because of the possibility of operating at high voltages, as well as at high breakdown voltages.

In each HEMT device, a semiconductive heterostructure allows a so-called 2-dimensional electron gas (2DEG), forming a channel region of the HEMT device, to be generated in an electronically controllable manner. Furthermore, each HEMT device comprises a gate region; the HEMT device channel is modulated by the voltage on the gate region.

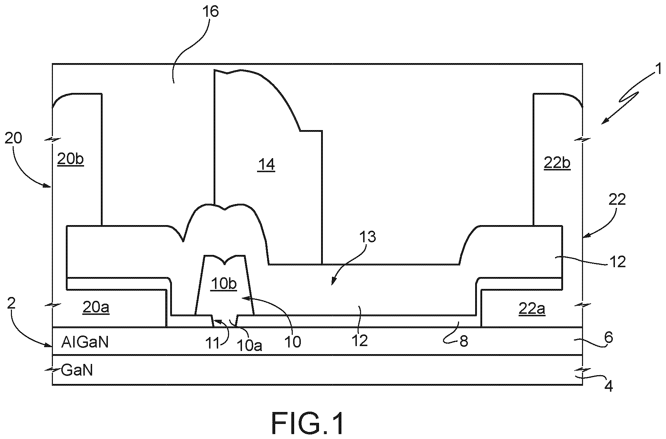

For example, Figure 1 shows a HEMT device 1, comprising a semiconductor body 2, here formed by a first and a second layers 4, 6, hereinafter also referred to as lower layer 4 and upper layer 6.

The lower layer 4 is formed by a first semiconductor material, such as for example a first semiconductive alloy of elements of the groups III and V of the periodic table; for example, the lower layer 4 may be formed by gallium nitride (GaN).

The upper layer 6 overlies, and is in direct contact with, the lower layer 4, and is formed by a second semiconductor material, such as for example a second semiconductive alloy, different from the first semiconductive alloy, of elements of the groups III-V of the periodic table. For example, the upper layer 6 may be formed by aluminium gallium nitride (AlGaN). The lower layer 4 and the upper layer 6 are for example of N-type. Although not shown, the semiconductor body 2 further comprises a substrate, typically of silicon or silicon carbide, on which the lower layer 4 is formed.

The HEMT device 1 further comprises a source metallization 20 and a drain metallization 22 arranged, at a mutual distance, above the upper layer 6.

A first insulating layer 8, for example of silicon nitride, extends above the upper layer 6 and part of the lower portions 20A, 22A of the source 20 and drain metallizations 22. Furthermore, the first insulating layer 8 has an opening 11 arranged at an intermediate position between the lower portions 20A, 20B of the source 20 and drain metallizations 22.

A gate region 10, of conductive material, extends partly within the opening 11 (with a lower gate portion 10A) and partly above the first insulating layer 8 (with an upper gate portion 10B) . The gate region 10 is formed, for example, by a stack of materials, such as nickel (Ni), gold (Au), platinum (Pt) and palladium (Pd), with the nickel layer directly in contact with upper layer 6 and forming therewith a metal-semiconductor junction of the Schottky type, that is rectifying. The above-mentioned stack of materials may also include aluminium.

A second insulating layer 12, for example of silicon nitride, extends above the first insulating layer 8 and surrounds the upper gate portion 10A. In practice, the second insulating layer 12 and the first insulating layer 8 form an insulating structure 13 sealing the gate region 10.

A field plate region 14 extends above the second insulating layer 12, partly vertically overlying the gate region 10 and partly laterally offset, towards the drain metallization region 22. The field plate region 14, for example of aluminium, has the aim of modifying the existing electric field during operation of the HEMT device 1. The field plate region 14 is electrically coupled to the source metallization 20, in a not shown manner.

A passivation layer 16, for example of silicon oxide, surrounds the upper portions 20B, 22B of the source 20 and drain metallizations 22 and the field plate region 14 and covers the whole structure.

Power devices made of GaN allow operational operation at high temperatures (for example, with base temperature in the range -50°C-150°C, and channel temperature up to 250°C). However, the performance and reliability of HEMT devices are reduced at such high temperatures. It is therefore essential to be able to make a measurement /estimate of the channel temperature of GaN-based HEMTs during their operation. An integrated temperature sensor may meet this requirement. The ideal location of a sensor is within the same die (integrated sensor) and in close proximity to the active region (channel).

Several solutions have been proposed for the realization of integrated sensors in GaN-based HEMTs, among which: 2DEG-based resistors, IC circuits that exploit the temperature-dependent characteristics of Schottky barrier diodes, enhancement-/depletion-mode HEMT, lateral field-effect rectifier; Un-Gated HEMTs; Schottky gate-diode HEMTs; Resistive temperature sensor (in Pt or Ni materials); Resistive linear temperature sensor on interconnection metallization.

All of the above-mentioned solutions have drawbacks. For example, the 2DEG-based resistors have nonlinear temperature dependence and cannot be formed in close proximity to the transistor channel; the IC circuits need particularly complex GaN HEMT technologies that require very complicated manufacturing processes; Un-Gated HEMTs require an ad hoc structure and cannot be formed in close proximity to the main transistor channel; Schottky gate-diode HEMTs are sensitive to trapping and bias effects and require appropriate readout strategy so as not to interfere with transistor operation; resistive temperature sensors require appropriate metal layer and additional masks for their manufacture; resistive linear temperature sensor on interconnection metallization require dedicated area which impacts on packaging and interrupts the periodicity of the structure.

The aim of the present invention is to provide a HEMT device with integrated temperature sensor that overcomes the above-mentioned issues.

According to the present invention, there are provided a semiconductor device, a system comprising the semiconductor device, and to a method of operating the semiconductor device, as defined in the attached claims.

For a better understanding of the present invention, some embodiments thereof are now described, purely by way of non-limiting example, with reference to the attached drawings, wherein:
- Figure 1 schematically shows a cross-section of a HEMT device known in the art;
- Figure 2 schematically shows a cross-section of an embodiment of a HEMT device according to an embodiment;
- Figure 3 schematically shows a cross-section of an embodiment of a HEMT device according to another embodiment;
- Figures 4A-4C are top plan views of part of the HEMT device of Figure 2, in subsequent manufacturing steps, according to an embodiment;
- Figures 5A and 5B are top plan views of part of the HEMT device of Figure 2, according to an embodiment of the invention; and
- Figure 6 is a system comprising the HEMT device of Figure 2, according to an embodiment of the invention.

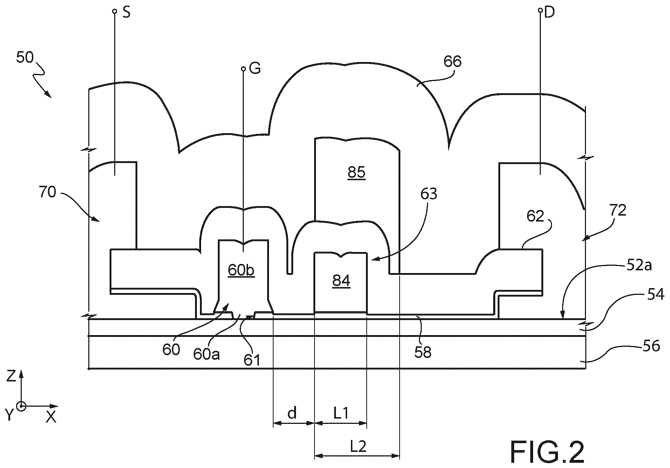

Figure 2 shows an embodiment of a HEMT device, generally identified with reference numeral 50. Figure 2 is a schematic representation of the HEMT device in lateral cross-section view, in a Cartesian system of mutually orthogonal axis X, Y, Z.

The HEMT device 50 comprises a semiconductor body 52, here formed by a lower layer 56, for example, of gallium nitride (GaN), and an upper layer 54, for example, of aluminium gallium nitride (AlGaN). The upper layer 54 forms a surface 52a of the semiconductor body 52. In a manner not shown in the drawings, the semiconductor body 52 may further comprise a silicon substrate and/or the upper layer 54 may be a multilayer, including layers of AlGaN with different percentage of aluminum (for example one AlGaN layer with 20% of aluminum and another AlGaN layer with 40%).

A source metallization 70 and a drain metallization 72 extend, at a mutual distance, above the body 52. The source 70 and drain metallizations 72 comprise lower portions 70a, 72a and upper portions 70b, 72b, and are, for example, of aluminium. The source 70 and drain metallizations 72 form source and drain electrodes and are electrically coupled to respective source and drain terminals S, D.

A first insulating layer 58, for example of silicon nitride, extends above the upper layer 54 and above part of the lower portions 70a, 72a of the source and drain metallizations 70, 72.

The HEMT device 50 further comprises a gate region 60 having a lower gate portion 60a and an upper gate portion 60b. The gate region 60 may be formed of one and a same conductive material, or otherwise may be a stack of materials, for example nickel (Ni), aluminium Al and tungsten nitride (WN) or tantalum nitride (TaN).

The first insulating layer 58 has an opening 61 accommodating the lower gate portion 60a. The gate region 60 is electrically coupled to a gate terminal G.

The HEMT device 50 has a first and a second field plate region 84, 85, of conductive material such as a metal, for example of Aluminium, or Platinum, or Nickel, or Copper.

The first field plate region 84 extends above the insulating layer 58 and is coated, laterally and on the top, by a second insulating layer 62. The second insulating layer 62, for example of silicon nitride, extends above the first insulating layer 58 and surrounds the upper gate portion 60a and the first field plate region 84 on the top and laterally. In practice, the second insulating layer 62 forms, with the first insulating layer 58, an insulation structure 63 sealing the gate region 60 and the first field plate region 84.

A passivation layer 66, for example of silicon oxide or silicon nitride, surrounds the upper portions 70b, 72b of the source and drain metallizations 70, 72 and covers the whole structure previously disclosed.

In the embodiment shown, the first field plate region 84 is arranged closer to the gate region 60 than to the drain metallization 72. For example, in the direction of axis X, in which the source metallization 70, the gate region 60, the first field plate region 84 and the drain metallization 72 are adjacent, the first field plate region 84 may have a width L1 chosen according to the breakdown voltage, for example comprised between 0.1 and 3 pm, for example of 1 pm, and may be arranged at a distance d of 0.1 to 3 pm, for example of 1 µm from the gate region 60 (the distance d being calculated, approximately, from the edge of the upper gate portion 60b facing the first field plate region 84).

The first field plate region 84 may be of a same conductive material, in particular of the same metal layer, and manufactured in the same manufacturing step as the upper gate portion 60b.

The second field plate region 85 extends above the second insulating layer 62, vertically overlying (with respect to axis Z) the first field plate region 84, and is covered by the passivation layer 66. The second field plate region 85 has a width L2 at least equal to, but generally greater than, the width L1 of the first field plate region 84. For example, the width L2 of the second field plate region 85 may be comprised between 0.1 and 5 pm.

The field plate regions 84, 85 are electrically coupled to the source metallization 70. In particular, the second field plate region 85 may be formed together with and using the same metal layer as the upper portions 70b and 72b of the source and drain regions 70, 72.

The field plate regions 84, 85 have the effect of modifying the existing electric field and in particular making it more uniform during the operation of the HEMT device 50. Furthermore, the presence of the first field plate region 84 allows the gain of the HEMT device 50 to be increased with respect to a HEMT device in which a corresponding field plate is absent. In fact, in case of an increase in the drain voltage, the first field plate region 84, acting as a shield between the gate region 60 and the drain metallization 72, has the effect of decreasing the gate-drain capacity to which the gain is inversely related.

In one embodiment, the lower gate portion 60a and the upper gate portion 60b may be formed by a single deposited (for example "sputtered") metal layer or a single evaporated layer or by a stack of layers deposited separately. In the latter case, the first field plate region 84 may be formed with one of the layers of the gate region 60.

It is clear that modifications and variations may be made to the HEMT device described and illustrated with reference to figure 2. For example, the second field plate 85 and the first field plate 84 may be connected in various ways to the source metallization 70; the first field plate 84 and the gate region 60 may be positioned in different ways with respect to the insulating layer 58; and the gate region 60 may be defined in different ways.

The second field plate 85 may be connected to the source metallization 70 through connecting regions extending either over an active area (where the 2-dimensional electron gas - 2DEG- forms a channel region of the HEMT device and conducts current) or an inactive area surrounding the active area.

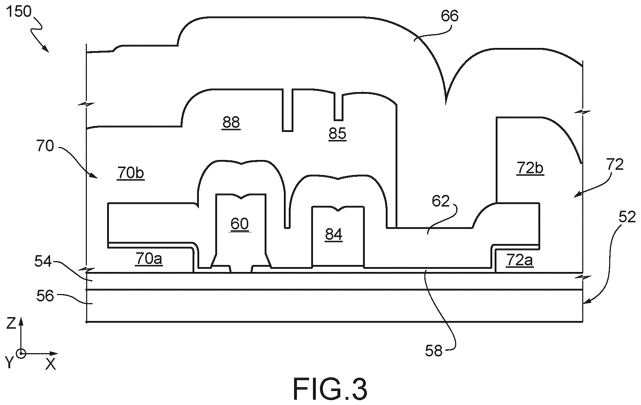

For example, Figure 3 shows an embodiment where the HEMT device 50 of Figure 2 has the second field plate 85 connected to the source metallization 70 through a connecting portion formed in the third metal layer which also forms the upper portion 70b of the source metallization 70, the upper portion 72b of the drain metallization 72 and the second field plate region 85, and thus defined in the same etching step. In particular, in Figure 3, a biasing metal portion 88 extends on the second insulating layer 62 between the upper portion 70b of the source metallization 70 and the second field plate region 85 and forms a single region with them.

According to a different embodiment, the second field plate 85 is connected to the source metallization 70 through a connecting region extending over the inactive area of the HEMT device 50.

It is intended that the HEMT device 150 may comprise a plurality of elementary cells, each having at least one source metallization 70, at least one drain metallization 72, at least one first field plate 84, and at least one second field plate 85, extending as fingers along the direction of axis Y.

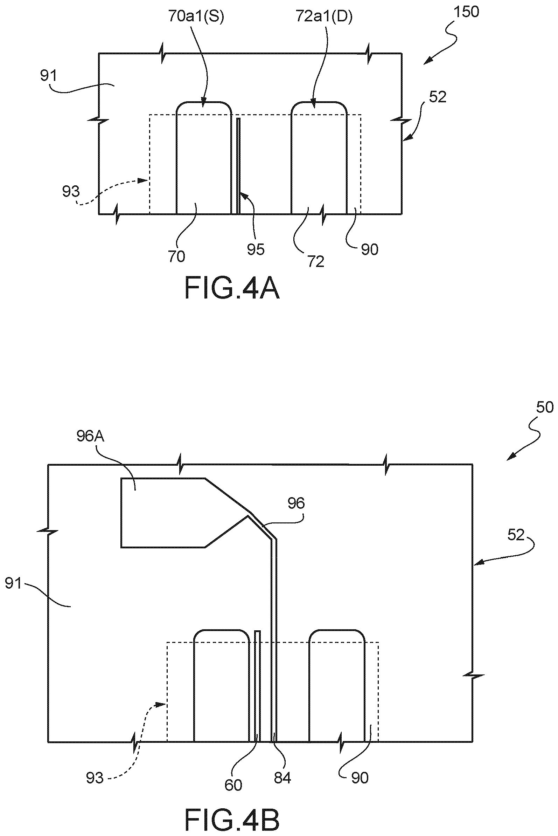

Reference is now made to figures 4A-4C.

The first field plate 84 may be connected to the source metallization 70 through connecting regions extending over the inactive area 91 or through the second field plate 85.

An active area 90 accommodates high mobility conduction electrons of the 2-DEG, and is surrounded by an inactive area 91, not participating in the electrical conduction when the transistor is the ON-state (switched on). The inactive area 91 is generally doped, to avoid passage of current when the HEMT device 50 is switched off. Line 93 indicates the boundary of the active area 90.

In one example, the first field plate 84 may be connected to the source metallization 70 as represented in Figures 4A-4C, which show the structure of an elementary cell of the HEMT device 50 of Figure 2 in three intermediate manufacturing steps (connection over the inactive area 91).

The HEMT device 50 may comprise a plurality of elementary cells, each having at least one source metallization 70, at least one drain metallization 72, at least one first field plate 84, and at least one second field plate 85, extending as fingers along the direction of axis Y.

Figure 4A shows a portion of the intermediate structure of the HEMT device 50 after forming the lower portions 70a, 72a of the source and drain metallizations 70, 72, and after forming and defining the insulating layer 58.

In figure 4A, the lower portions 70a, 72a of the source 70 and drain metallizations 72 extend mainly on the active area 90 and have ends portions 70a1, 72a1 extending on the inactive area 91.

Figure 4B shows the same portion of the intermediate structure of the HEMT device 50 after depositing and defining a metal layer, so as to form the gate region 60, the first field plate 84 and a first connecting region 96. The first connecting region 96 is extends at a first end of the strip forming the first field plate 84. In particular the connecting region 96 is integral with and is in prosecution of the first field plate 84. The connecting region 96 extends from the first end of the first field plate 84 onto the inactive area 91 and connects electrically the first field plate 84 to an enlarged portion 96a. The enlarged portion 96a is of electrically conductive material; in one embodiment, the enlarged portion 96a is integral with and is in prosecution of the connecting region 96.

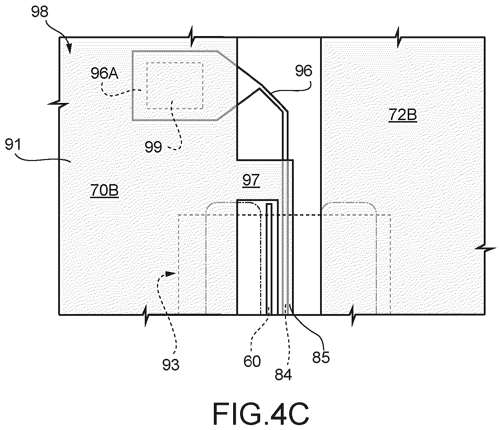

One further embodiment envisages depositing and defining the second insulating layer 62 and depositing and defining a third metal layer 98, to form the upper portions 70b and 72b of the source and drain metallizations 70, 72 and the second field plate region 85. Accordingly, Figure 4C shows the same portion of Figures 4A and 4B after depositing and defining the second insulating layer 62 (not visible in Figure 4C) and depositing and defining the third metal layer 98, to form the upper portions 70b and 72b of the source and drain metallizations 70, 72 and the second field plate region 85.

In Figure 4C, the second insulating layer 62 has been defined to form a through opening 99 over the enlarged portion 96a of the first connecting region 96.

The third metal layer 98 also extends over the inactive region 91 and in particular over the enlarged portion 96a and fills the through opening 99 to form a connection via (indicated by the same number 99 since it has the same shape as the through opening). The connection via 99 electrically connects the upper portion 70b of the source metallization 70 to the enlarged portion 96a of the first connecting region 96 (at a lower level) and thus to the first field plate 84.

Here, in addition, the third metal layer 98 is also defined to form the second field plate connecting region 97 extending over the inactive area 91 between the upper portion 70b of the source metallization 70 and the second field plate region 85.

In all the previously discussed embodiments, the first field plate 84 may be arranged in different ways with respect to the insulating layer 58. In particular, as an alternative to the arrangement shown in Figure 2, where the first field plate 84 is formed completely over the insulating layer 58, the first field plate 84 may be formed with its lower portion inside the insulating layer 58.

According to a different embodiment, the first field plate 84 may be formed to contact the semiconductor body 52. In this case, the insulating layer 58 may be removed only partially.

The gate region 60 may extend directly on and physical in contact with the semiconductor body 52, or may enter a recess in the semiconductor body 52.

The gate region 60 and the first field plate 84 may be defined through known masking and etching steps, in which case the insulating layer 58 is slightly recessed as a consequence of the etching process, or using a lift-off process. In this case, the insulating layer 58 has a planar upper surface, not recessed.

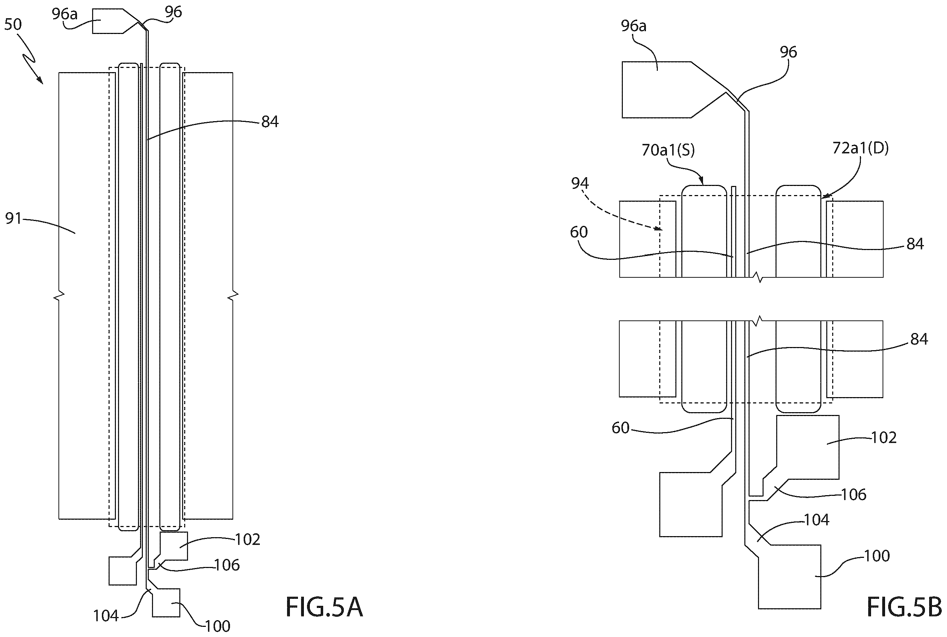

According to an aspect of the invention, shown in Figure 5, the first field plate 84 is used as a temperature or thermal sensor. The measuring the temperature may be carried out either when the device is switched-on (i.e., it is in electrical conduction state) or when the device is switched-off (i.e., it is not in electrical conduction state).

To this regard, the first field plate 84 may be connected to a first metal pad 100 and to a second metal pad 102 used for forcing a current to the first field plate 84 and to sense a voltage across the first field plate 84. Figure 5A is a representation of the HEMT device using the same top-plan view of Figures 4A-4C. The metal pads 100, 102 are formed at a second end of the first field plate 84 opposite to the first end of the first field plate 84 to which the enlarged portion 96a is coupled. Figure 5B is an enlarged view of portions of Figure 5A.

The metal pads 100, 102 are electrically coupled to the second end of the first field plate 84 through respective second and third connecting regions 104, 106.

The connecting regions 104, 106 are integral with and in prosecution of the first field plate 84 at the second end. The connecting regions 104, 106 extend from the second end of the first field plate 84 onto the inactive area 91 and connect electrically the first field plate 84 to the metal pads 100, 102. In one embodiment, the metal pads 100, 102 are integral with and in prosecution of the connecting regions 104, 106.

The connecting region 96 is coupled to the first field plate 84 at a region of the first field plate 84 that is closer to the first end than to the second end of the first field plate 84.

The connecting region 104 is coupled to the first field plate 84 at a region of the first field plate 84 that is closer to the second end than to the first end of the first field plate 84.

The connecting region 106 is coupled to the first field plate 84 at a region of the first field plate 84 that is closer to the second end than to the first end of the first field plate 84.

In one embodiment, the portion of the first field plate extending along the direction of the Y axis from the connecting region 96 and the connecting region 104 (or the connecting region 106) is in the range 25 pm - 1.5 mm.

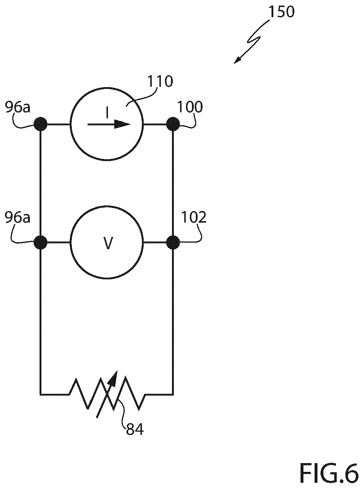

Reference is now made to Figures 5A, 5B and Figure 6. Figure 6 illustrates schematically a system 150 including the device 50 according to any one of the embodiments previously disclosed. To use the first field plate 84 as a temperature sensor, a current I is fed to the metal pad 100 by a current generator 110; the current flows from the metal pad 100 to the enlarged portion 96a, or viceversa (by properly biasing the metal pad 100 and the enlarged portion 96a). A voltage V is sensed by voltage sensor 112 across the first field plate 84 using the metal pad 102 and the enlarged portion 96a as sensing terminals. Since, as it is known, the resistance (resistivity) R of the material (metal) of the first field plate 84 varies as a consequence of its current temperature, sensing of the voltage V provides an indirect measure of the temperature of the first field plate 84. This temperature may be assumed to be substantially equal to the temperature of the active region (channel). The first field plate 84 is thus operated as a resistance temperature detector (RTD).

The measurement method represented in Figure 6 is also known as 2-wire (two-wire) measurement: a current source I (with a high output impedance) excites the RTD, thus resulting in a voltage drop that is measured with a circuit whose input impedance is high. The operating principle of RTDs rely on the fact that the resistivity (and, hence, the electrical resistance) of a (pure) metal increases with increasing temperature. The physics behind this operating principle is that a temperature increase makes the thermal vibration of atoms higher and, hence, the electrons undergo a decrease of the mean time between collisions, thus increasing the resistivity of the metal. The metal most employed to manufacture RTD is Platinum. However, other metals are possible and envisaged by the present invention for manufacturing the first field plate 84, as already discussed. Generally, Platinum can withstand high temperatures with good stability and, in addition, it is a noble metal that shows an outstanding resistance to chemical attacks and pollution. Other metals employable are Nickel and Copper. Other metals employable may include Aluminium.

The temperature input range for platinum-based RTD is from -200 to +850°C, whereas for nickel- and copper-based counterparts is from -80 to +320°C, and from -200 to +260°C, respectively. The sensitivity of nickel-based RTDs is almost twice that offered by platinum-based RTD, but with less linearity.

Other circuit implementations may be envisaged for manufacturing the integrated temperature sensor according to the present invention. For example, the 4-wire (four-wire) measurement, also known as Kelvin resistance measurement, may be employed.

The effect of a current injected from one side of the field plate 84 when used as a thermal sensor may create a transversal depolarization of the field plate 84. However, this effect is negligible due to the very low current value required from the control circuitry to detect the voltage increase. Currents I injected are in fact of the order of 100µA-100mA.

As shown in Figure 6, a control circuitry is also provided externally to the HEMT device 50, to inject current in the field plate 84 and acquire/monitoring the voltage drop across the field plate 84, when used as a thermal sensor. Surge stoppers may be implemented at the detection side of the control circuitry to avoid possible injection of current spikes on the field plate 84 from the control circuitry.

The thermal sensor disclosed above can also be applied to HEMT devices based on GaAs, as an alternative to GaN.

The thermal sensor disclosed above can also be implemented in semiconductor devices different from a HEMT, such as a LDMOS transistor with field plate connected to source.

## Claims

1. A semiconductor device (50) comprising:
a semiconductor body (52) having a semiconductive heterostructure (54, 56);
a gate region (60), of conductive material, arranged on and in contact with the semiconductor body (52);
a first insulating layer (58) extending over the semiconductor body, laterally to the conductive gate region (60) ;
a second insulating layer (62) extending over the first insulating layer (58) and the gate region (60);
a first field plate (84), of metal material, extending between the first and the second insulating layers (58, 62), laterally spaced from the conductive gate region (60), the first field plate (84) having, in a top-plan view, a strip-like shape with main extensions along a first direction (Y), the strip-like shape having a first and a second end opposite to one another along said first direction (Y);
a first conductive pad (96a) in electrical contact with the first field plate (84) at the first end through a first connecting region;
a second conductive pad (104) in electrical contact with the first field plate (84) at the second end through a second connecting region; and
a third conductive pad (106) in electrical contact with the first field plate (84) at the second end through a third connecting region.

2. The device according to claim 1, wherein the first field plate region (84) is of a pure metal, in particular one among Platinum, Nickel, Copper, Aluminium.

3. The device according to claim 1 or 2, wherein the first connecting region is closer to the first end than to the second end; and wherein both the second and third connecting regions are closer to the second end than to the first end.

4. The device according to anyone of the preceding claims, wherein the first connecting region is coupled to the first field plate (84) at a first intersection point, the second connecting region is coupled to the first field plate (84) at a second intersection point, and the third connecting region is coupled to the first field plate (84) at a third intersection point,
the length, along said first direction (Y), of the first field plate (84) from the first intersection point to at least one of the second and third intersection points is in the range 25pm-1.5mm.

5. The device according to anyone of the preceding claims, wherein the semiconductor body (52) comprises at least a first semiconductor layer (54) including aluminium gallium nitride, AlGaN, and a second semiconductor layer (56) including one among gallium nitride, GaN, and Gallium Arsenide, GaAs, and wherein the second semiconductor layer (56) is contiguous to the first insulating layer (58).

6. The device according to anyone of the preceding claims, wherein:
the first field plate (84), the first, second and third conductive pads (96a, 104, 106), and the first, second and third connecting regions (96, 100, 102) form a resistance temperature detector, RTD;
the first, second and third conductive pads (96a, 104, 106) are terminals of the RTD; and
the first field plate (84) has a temperature-dependent electrical resistivity.

7. The device according to anyone of the preceding claims, further comprising a second field plate (85), of conductive material, extending over the second insulating layer (62), the second field plate region overlying the first field plate (84).

8. The device according to anyone of the preceding claims, further comprising a drain contact region (72) and a source contact region (70), of electrically conductive material, extending over and in electrical contact with the semiconductor body (52), through the first and the second insulating layers (58, 62) on opposite sides of the gate region (60), wherein the first field plate region (84) extends between the gate region and the drain contact region (72) .

9. The device according to claim 8, wherein the first conductive pad (96a) is electrically coupled to the source contact region (70).

10. The device according to anyone of the preceding claims, wherein the first field plate region (84) has a first width (L1), along a second direction (X) transverse to the first direction (Y), and the second field plate region (85) has a second width (L2), along the second direction (X), wherein the second width is greater than the first width.

11. The device according to anyone of the preceding claims, wherein:
the first insulating layer (58) extends on, and in direct contact with, the semiconductor body (52), and
the first field plate region (84) extends on, and in direct contact with, the first insulating layer (58).

12. The device according to anyone of claims 1-10, wherein the first field plate region (84) extends on, and in direct contact with, the semiconductor body (52).

13. The device according to anyone of the preceding claims, wherein the gate region (60) has a base portion (60a), and the first insulating layer (58) has a passing aperture (61) exposing a surface portion (52a) of the semiconductor body (52),
the base portion (60a) of the gate region (60) extending within said passing aperture (61) and being in direct contact with said surface portion (52a) of the semiconductor body (52) through said passing aperture (61).

14. A system, comprising:
a device according to anyone of claims 1-13, in particular one among: a HEMT, a LDMOS transistor;
a control circuitry, having:
a current-generator, coupled to the first conductive pad (96a) and to one among the second and the third conductive pad (104, 106), operable to cause an electrical current (I) to flow through the first field plate (84) between the first conductive pad (96a) and the one among the second and the third conductive pad (104, 106); and
a voltage-sensor, coupled to the first conductive pad (96a) and to other among the second and the third conductive pad (104, 106), operable to sense a voltage drop (V) across the first field plate (84) when said electrical current (I) flows through the first field plate (84).

15. The system of claim 14, further comprising computing means configured to associate values of said voltage drop (V) to corresponding values of temperature.

16. A method of operating a device according to anyone of claims 1-13, comprising:
cause an electrical current (I) to flow through the first field plate (84) between the first conductive pad (96a) and the one among the second and the third conductive pad (104, 106);
sense a voltage drop (V) across the first field plate (84) when said electrical current (I) flows through the first field plate (84); and
associate values of said voltage drop (V) to corresponding values of temperature.
